# EUROPÄISCHE PATENTANMELDUNG

(11) **EP 4 564 850 A1**
(43) Veröffentlichungstag der Anmeldung: **04.06.2025**
(21) Anmeldenummer: 24214318.8
(22) Anmeldetag: 20.11.2024
(51) Int. Cl.: H04R 19/00, H04R 17/00

(54) **MEMS-WANDLER MIT EINER TRÄGERSCHICHT UND ZUMINDEST ZWEI PIEZOSCHICHTEN**

(30) Priorität: 29.11.2023 DE 102023133447
(71) Anmelder: USound GmbH, 8020 Graz (AT)
(72) Erfinder: RUSCONI CLERICI BELTRAMI, Andrea, 1130 Wien (AT); BOTTONI, Ferruccio, 8020 Graz (AT); NOVOTNY, Christian, 1120 Wien (AT); HORVÁTH, Samu Bence, 1020 Wien (AT)
(74) Vertreter: Canzler & Bergmeier Patentanwälte Partnerschaft mbB

(57) **Zusammenfassung**

Die Erfindung betrifft einen MEMS-Wandler (1), insbesondere MEMS-Schallwandlereinheit, vorzugsweise zum Erzeugen und/oder Erfassen von Schallwellen im hörbaren Wellenlängenspektrum und/oder im Ultraschallbereich, mit einem Träger (2) und mit zumindest einem am Träger (2) angeordneten und in Richtung einer Hubachse (3) auslenkbaren Piezoelement (4), das zumindest zwei Piezoschichten (5, 25, 35, 36) und zumindest eine Trägerschicht (6) aufweist, wobei mittels der zumindest einen Piezoschicht (5, 25, 35, 36) elektrische Signale und Auslenkungen des Piezoelements (4) ineinander umwandelbar sind. Erfindungsgemäß ist die Trägerschicht (6) in Richtung der Hubachse (3) zwischen zwei Piezoschichten (5, 25, 35, 36) angeordnet. Außerdem betrifft die Erfindung eine Verwendung der Trägerschicht (6) für MEMS-Wandler (1) und ein Herstellungsverfahren des MEMS-Wandlers (1).

## Beschreibung

Die vorliegende Erfindung betrifft einen MEMS-Wandler, insbesondere eine MEMS-Schallwandlereinheit, vorzugsweise zum Erzeugen und/oder Erfassen von Schallwellen im hörbaren Wellenlängenspektrum und/oder im Ultraschallbereich, mit einem Träger und mit zumindest einem am Träger angeordneten und in Richtung einer Hubachse auslenkbaren Piezoelement, das zumindest zwei Piezoschichten und zumindest eine Trägerschicht aufweist, wobei mittels der zumindest einen Piezoschicht elektrische Signale und Auslenkungen des Piezoelements ineinander umwandelbar sind.

Aufgabe der Erfindung ist es, leistungsfähige MEMS-Wandler zu schaffen.

Die Aufgabe wird gelöst durch einen MEMS-Wandler, eine Verwendung einer Trägerschicht für MEMS-Wandler und ein Herstellungsverfahren des MEMS-Wandlers mit den Merkmalen der unabhängigen Patentansprüche. Vorteilhafte oder bevorzugte Ausführungen sind jeweils Gegenstand eines korrespondierenden abhängigen Anspruchs.

Vorgeschlagen wird ein MEMS-Wandler, vorzugsweise ein MEMS-Schallwandler, insbesondere zum Erzeugen und/oder Erfassen von Schallwellen im hörbaren Wellenlängenspektrum und/oder im Ultraschallbereich. Der MEMS-Wandler kann als Lautsprecher und/oder als Mikrofon und somit als MEMS-Schallwandler betrieben werden.

Der MEMS-Schallwandler umfasst einen Träger.

Des Weiteren umfasst der MEMS-Wandler zumindest ein am Träger angeordnetes und in Richtung einer Hubachse auslenkbares Piezoelement.

Außerdem weist das zumindest eine Piezoelement zumindest zwei Piezoschichten und zumindest eine Trägerschicht auf, wobei mittels der Piezoschichten elektrische Signale und Auslenkungen des Piezoelements ineinander umwandelbar sind.

Außerdem ist zumindest eine Trägerschicht in Richtung der Hubachse zwischen zwei Piezoschichten angeordnet. Somit ist in Richtung der Hubachse zumindest eine Piezoschicht oberhalb und zumindest eine Piezoschicht unterhalb der Trägerschicht angeordnet. Hierdurch kann das Piezoelement symmetrisch ausgebildet werden, sodass die Auslenkungseigenschaften verbessert werden. Hierdurch kann auf einfache Weise erreicht werden, dass eine neutrale Ebene bzw. neutrale Schicht in Richtung der Hubachse mittig in der Trägerschicht angeordnet werden. Das Piezoelement ist ein Kragarm und bei der Auslenkung des Piezoelements bilden sich darin eine Druck- und eine Zugspannung auf. Die Bereiche der Druck- und der Zugspannung hängen davon ab, ob sich das Piezoelement nach oben oder nach unten auslenkt. Auf der Seite in dessen Richtung sich das Piezoelement auslenkt, werden die Druckspannungen ausgebildet. Auf der dazu gegenüberliegenden Seite bilden sich die Zugspannungen auf. Dies ist ein allgemeines Prinzip der Festigkeitslehre. In einer Ebene im Piezoelement, nämlich in der neutralen Ebene bzw. in der neutralen Schicht, heben sich die Zug- und die Druckspannung gegenseitig auf, sodass dort keine Spannung herrscht. Die Auslenkeigenschaften des Piezoelements hängen jedoch davon ab, an welchem Ort sich diese neutrale Ebene bzw. neutrale Schicht im Piezoelement befindet. Durch die zumindest eine Piezoschicht oberhalb und unterhalb der Trägerschicht ist diese neutrale Ebene mittig angeordnet.

Des Weiteren können sich durch diesen Aufbau des Piezoelements Nichtlinearitäten bei der Auslenkung der Piezoschichten automatisch aufheben, da diese symmetrisch auftreten und durch die eine Piezoschicht oberhalb und die andere Piezoschicht unterhalb sich die Nichtlinearitäten gegenseitig aufheben.

Vorteilhaft ist es, wenn die Piezoschichten aus Scandium-Aluminium-Nitrit ausgebildet sind. Derartige Piezoschichten sind sehr robust, was insbesondere an dem Scandiumanteil liegt, der vorzugsweise zwischen 30% und 70% betragen kann. Besonders vorteilhaft kann es sein, wenn der Scandiumanteil 30%, 40 oder 50% beträgt.

Von Vorteil ist es, wenn in Richtung der Hubachse unterhalb und oberhalb der Trägerschicht eine Piezoschicht angeordnet ist.

Förderlich ist es, wenn in Richtung der Hubachse unterhalb und oberhalb der Trägerschicht jeweils die gleiche Anzahl an Piezoschichten angeordnet sind. Hierdurch bleibt die Symmetrie des Piezoelements erhalten.

Ebenso ist es von Vorteil, wenn in Richtung der Hubachse unterhalb und oberhalb der Trägerschicht jeweils zwei Piezoschichten angeordnet sind. Hierdurch kann die Leistungsfähigkeit erhöht werden, ohne dass zu viele Piezoschichten vorhanden sind.

Vorteilhaft ist es, wenn die zumindest eine Trägerschicht zumindest eine Metallschicht, insbesondere eine Metallschicht, umfasst. Die Metallschicht kann ferner eine Aluminiumschicht sein. Zusätzlich oder alternativ kann die zumindest eine Trägerschicht zumindest eine Oxidschicht umfassen. Die Oxidschicht kann eine Siliziumoxidschicht sein. Mittels dieser Materialien kann die Trägerschicht mit bekannten Herstellungsverfahren, beispielsweise mittels Verfahren, die in der Halbleitertechnologie eingesetzt werden, ausgebildet werden. Die Trägerschicht kann infolgedessen in großen Mengen und/oder sehr kostengünstig hergestellt werden. Des Weiteren weise die Aluminium- und die Siliziumoxidschicht ein vergleichbares E-Modul von im Bereich von 70GPa auf. Dadurch weisen beide Schichten ähnlich bzw. fast gleiche Auslenkeigenschaften auf.

Die zumindest eine Oxidschicht und/oder zumindest eine Metallschicht weisen ferner den Vorteil auf, dass diese thermisch bis hohe Temperaturen, beispielsweise bis 1200°C - 1400°C, beständig sind. Infolgedessen können die Piezoschichten und/oder Elektrodenschichten mittels Verfahren der Halbleitertechnologie, beispielsweise eine CMOS-kompatiblen Verfahren, aufgebracht werden. Beispielsweise können die Piezoschichten und/oder die Elektrodenschichten mittels eines CVD-Verfahrens (chemische Gasphasenabscheidung) aufgebracht werden.

Ferner ist es von Vorteil, wenn die Trägerschicht mehrere Metallschichten und mehrere Oxidschichten umfasst. Die Metall- und die Oxidschichten können außerdem abwechselnd übereinander angeordnet sein. Hierdurch wird ein sandwichartiger Aufbau der Trägerschicht ausgebildet. Eine derartige Trägerschicht ist somit ein Stapel aus mehreren Schichten, vorzugsweise aus zumindest einer Metallschicht und zumindest einer, insbesondere zumindest zwei, Oxidschichten. Die Trägerschicht kann hierbei auch eine Strukturschicht sein.

Von Vorteil ist es, wenn in Richtung der Hubachse die oberste und die unterste Schicht eine Oxidschicht ist. Beim schichtweisen Aufbau der Trägerschicht mittels der zumindest einen Metallschicht und den zumindest zwei Oxidschichten, ist in Richtung der Hubachse die oberste und die unterste Schicht eine Oxidschicht. Dies hat den Vorteil, dass die Oxidschicht, insbesondere die Siliziumoxidschicht, die höchste Temperaturbeständigkeit aufweist. Auf diese Oxidschicht, die sowohl die oberste als auch die unterste Schicht bildet, wird die Piezoschicht und/oder die Elektrodenschicht, insbesondere bei höheren Temperaturen, aufgetragen. Die Oxidschicht verändert sich bei den höheren Temperaturen nicht.

Die Oxidschicht, insbesondere die Siliziumoxidschicht, kann außerdem auf einfache Weise bearbeitet werden. Beispielsweise kann diese Schicht chemisch-mechanisch poliert werden. Ein derartiges Verfahren ist unter Chemisch-mechanisches Polieren, auch chemisch-mechanisches Planarisieren (CMP, engl: "chemical mechanical polishing", auch "chemical mechanical planarization") bekannt. Die Oxidschicht, insbesondere die Siliziumoxidschicht, kann dadurch sehr flach und/oder eben ausgebildet werden.

Gemäß einer vorteilhaften Weiterbildung der Erfindung ist es nützlich, wenn die zumindest eine Trägerschicht aus einem Polymer ausgebildet ist. Das Polymer kann hierbei ein Polyamid sein. Mit Hilfe der zumindest einen Trägerschicht aus Polymer können höhere Auslenkungen des Piezoelements erreicht werden. Zusätzlich oder alternativ kann auch eine Länge des Piezoelements verkürzt werden, wobei die Auslenkungen zumindest konstant gehalten werden kann.

Es bringt Vorteile, wenn das Piezoelement in seiner Längsrichtung eine Länge, insbesondere vom Träger bis zu einem freien Ende des Piezoelements, zwischen 0,5mm und 2mm aufweist.

Vorteilhaft ist es, wenn das zumindest eine Piezoelement mehrere, insbesondere zwischen zwei und sechs, vorzugsweise vier, Piezoschichten umfasst.

Ein Vorteil resultiert, wenn das zumindest eine Piezoelement zumindest eine Elektrodenschicht umfasst. Mit Hilfe der zumindest einen Elektrodenschicht können die elektrischen Signale ausgetauscht werden, die zur Auslenkung des Piezoelements führen und/oder die ausgebildet werden, wenn das Piezoelement ausgelenkt wird.

Von Vorteil ist es, wenn das zumindest eine Piezoelement zumindest eine Isolationsschicht umfasst.

Vorteilhaft ist es, wenn das zumindest eine Piezoelement sandwichartig aus den mehreren Piezoschichten und den Elektrodenschichten ausgebildet ist.

Ein Vorteil resultiert, wenn der MEMS-Schallwandler ein Koppelelement umfasst, mit dem das zumindest eine Piezoelement mit einer Membran koppelbar ist.

Eine Verbesserung resultiert, wenn das Piezoelement und das Koppelelement mittels zumindest eines Federelements miteinander gekoppelt sind, wobei das zumindest eine Federelement in Längsrichtung des Piezoelements vorzugsweise zwischen der Trägerschicht und dem Koppelelement angeordnet ist.

Vorteile bringt es mit sich, wenn das Federelement, vorzugsweise ausschließlich, durch die Trägerschicht ausgebildet ist. Hierdurch kann das Federelement auf einfache Weise ausgebildet werden.

Von Vorteil ist es, wenn das Federelement aus dem oder einem Polymer, insbesondere aus Polyamid, ausgebildet ist. Zusätzlich oder alternativ weist das Federelement die mechanischen Eigenschaften des Polymers auf.

Es ist förderlich, wenn das Piezoelement und das Koppelelement zueinander denselben schichtweisen Aufbau aufweisen.

Eine Verbesserung resultiert, wenn die Trägerschicht zwischen 5µm und 100µm dick ist. Vorzugsweise weist die Trägerschicht eine Dicke geringer als 100µm auf.

Des Weiteren ist es vorteilhaft, wenn die Trägerschicht ein E-Modul zwischen 40 und 300GPa aufweist.

Durch die oben genannten mechanischen Eigenschaften der zumindest einen Trägerschicht können die Auslenkungen vergrößert und/oder das Piezoelement bei zumindest gleichbleibender Größe der Auslenkung oder bei Vergrößerung der Auslenkung verkürzt werden.

Des Weiteren wird eine Verwendung der Trägerschicht für den MEMS-Wandler vorgeschlagen. Der MEMS-Wandler weist dabei zumindest ein Merkmal der vorangegangenen und/oder nachfolgenden Beschreibung auf. Zusätzlich oder alternativ weist die Trägerschicht zumindest ein Merkmal der vorangegangenen und/oder nachfolgenden Beschreibung auf. Insbesondere kann die Trägerschicht zumindest eine Metallschicht, insbesondere eine Aluminiumschicht, und/oder zumindest eine Oxidschicht, insbesondere eine Siliziumoxidschicht, und gegebenenfalls zumindest ein weiteres damit verbundenes Merkmal umfassen.

Vorgeschlagen wird außerdem ein Verfahren zur Herstellung eines MEMS-Wandlers, vorzugsweise eines MEMS-Schallwandlers, insbesondere zum Erzeugen und/oder Erfassen von Schallwellen im hörbaren Wellenlängenspektrum und/oder im Ultraschallbereich. Das Verfahren zur Herstellung des MEMS-Wandlers kann dabei derart durchgeführt werden, dass der MEMS-Wandler mit zumindest einem Merkmal der vorangegangenen und/oder nachfolgenden Beschreibung ausgebildet wird.

Beim Verfahren wird auf einem Träger zumindest ein Piezoelement ausgebildet, das zumindest zwei Piezoschichten und zumindest eine damit gekoppelte Trägerschicht umfasst.

Des Weiteren wird beim Verfahren die Trägerschicht zwischen zumindest zwei Piezoschichten angeordnet. Hierdurch kann ein symmetrischer Aufbau des Piezoelements, insbesondere in Richtung der Hubachse, ausgebildet werden. Infolgedessen können vorteilhafte Auslenkungseigenschaften erreicht werden.

Ebenso ist es förderlich, wenn eine Oxidschicht, insbesondere eine Siliziumoxidschicht, mittels chemisch-mechanischem Polierens bearbeitet wird. Hierdurch wird die Oxidschicht flach und/oder eben ausgebildet. Auf diese flache und/oder ebene Oxidschicht wird dann die zumindest eine Piezoschicht und/oder eine Elektrodenschicht aufgebracht.

Von Vorteil ist es, wenn die Piezoschichten mittels Halbleiterherstellungsverfahren auf der Trägerschicht ausgebildet werden.

Vorteilhaft ist es außerdem, wenn die Piezoschichten auf der Trägerschicht abgeschieden werden. Die Piezoschicht, zumindest die erste Piezoschicht, kann hierbei auch auf der Oxidschicht abgeschieden werden. Alle weiteren folgenden Piezoschichten werden dann aufeinander abgeschieden.

Ebenso ist es von Vorteil, wenn die Piezoschichten auf der Trägerschicht und/oder die Trägerschicht mittels chemischer Gasphasenabscheidung ausgebildet werden. Hierdurch werden gut verstandene Verfahren zur Ausbildung der Piezoschichten und/oder der Elektrodenschichten angewandt. Außerdem können derartige Verfahren besonders einfach durchgeführt werden.

Die Metallschicht, die Oxidschicht, die Elektrodenschicht und/oder die Piezoschicht können hierbei mit CMOS-kompatiblen Verfahren ausgebildet und/oder, insbesondere auf bereits bestehenden Schichten, angeordnet werden.

Weiterhin ist es förderlich, wenn nach dem Ausbilden der Piezoschichten und/oder der Trägerschicht zumindest ein Bereich, insbesondere mittels Ätzens, entfernt wird. Mit Hilfe der hier beschriebenen Verfahrensschritte können die Piezoschichten und/oder die Trägerschicht aufeinander aufgebaut werden.

Nützlich ist es, wenn die Piezoschichten aus Scandium-Aluminium-Nitrit ausgebildet werden.

Ferner ist es vorteilhaft, wenn das zumindest eine Piezoelement mit mehreren, insbesondere zwischen zwei und sechs, insbesondere vier, Piezoschichten ausgebildet wird. Mittels mehrerer Piezoschichten kann die Leistung des Piezoelements erhöht werden.

Des Weiteren ist es von Vorteil, wenn in Richtung der Hubachse oberhalb und unterhalb der Trägerschicht die gleiche Anzahl an Piezoschichten angeordnet wird.

Beispielsweise ist es von Vorteil, wenn in Richtung der Hubachse oberhalb und unterhalb der Trägerschicht jeweils zwei Piezoschichten angeordnet sind, sodass das Piezoelement insgesamt vier Piezoschichten umfasst.

Förderlich ist es, wenn das zumindest eine Piezoelement sandwichartig aus den mehreren Piezoschichten und zumindest einer Elektrodenschicht ausgebildet wird.

Die mehreren Piezoschichten und mehreren Elektrodenschichten können abwechselnd übereinander angeordnet sein.

Des Weiteren ist es vorteilhaft, wenn beim Ausbilden des zumindest einen Piezoelements zumindest eine Isolationsschicht angeordnet wird.

Nützlich ist es, wenn die Trägerschicht aus dem Polymer auf einer dem Träger abgewandten Seite der Piezoschicht angeordnet wird.

Eine Verbesserung resultiert, wenn die Trägerschicht aus dem Polymer auf der zumindest einen Piezoschicht angeordnet wird, nachdem die Piezoschicht und/oder ein Koppelelement ausgebildet sind und/oder nachdem der Träger, die Piezoschicht und/oder das Koppelelement, insbesondere mittels Ätzens, nachbearbeitet, insbesondere voneinander getrennt, sind.

Es ist förderlich, wenn das Piezoelement und das Koppelelement zusammen schichtweise ausgebildet werden, wobei dies vorzugsweise auf dem Träger erfolgt.

Es bringt Vorteile, wenn nach dem schichtweisen Aufbauen des Piezoelements und des Koppelelements diese, insbesondere mittels Ätzens, zumindest abschnittweise voneinander getrennt werden.

Des Weiteren kann ein Verfahren durchgeführt werden, um dem MEMS-Wandler gemäß einem oder mehreren der vorangegangenen und/oder nachfolgenden Beschreibung zu schaffen.

Weitere Vorteile der Erfindung sind in den nachfolgenden Ausführungsbeispielen beschrieben. Es zeigen:
- **Figur 1**: eine schematische Schnittansicht eines MEMS-Wandlers mit einem Piezoelement aus zwei Piezoschichten und zumindest einer Trägerschicht,
- **Figur 2**: eine schematische Schnittansicht des Piezoelements mit zwei Piezoschichten und zumindest einer Trägerschicht,
- **Figur 3**: eine schematische Schnittansicht des Piezoelements mit jeweils zwei Piezoschichten in Richtung der Hubachse oberhalb und unterhalb der Trägerschicht,
- **Figur 4**: eine schematische Schnittansicht der Trägerschicht aus Metallschichten und Oxidschichten,
- **Figur 5**: eine Draufsicht auf einen MEMS-Wandler mit mehreren Piezoelementen.

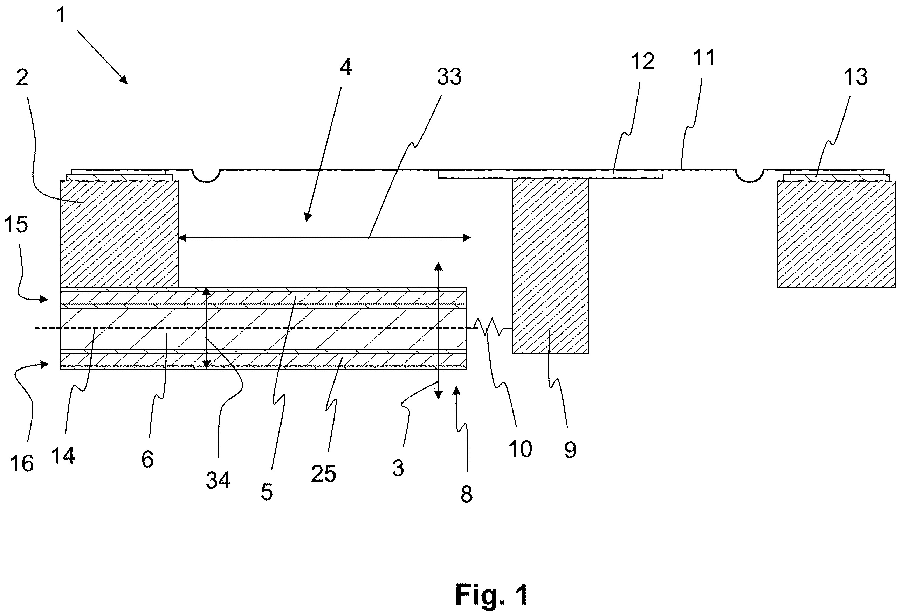

Figur 1 zeigt eine schematische Schnittansicht eines MEMS-Wandlers 1. Der MEMS-Wandler 1 kann auch ein MEMS-Schallwandler sein. Mittels des MEMS-Schallwandlers können beispielsweise Schallwellen im hörbaren Wellenlängenspektrum erzeugt werden, sodass dieser als MEMS-Lautsprecher betrieben werden kann. Mit Hilfe des MEMS-Schallwandlers können zusätzlich oder alternativ Schallwellen im hörbaren Wellenlängenspektrum erfasst werden, sodass dieser als MEMS-Mikrofon betrieben werden kann. Der MEMS-Schallwandler kann ferner beispielsweise in einem Smartphone angeordnet sein, um beispielsweise das Telefonieren oder das Hören von Musik zu ermöglichen. Der MEMS-Schallwandler kann beispielsweise auch in einem Kopfhörer angeordnet sein. Mittels des MEMS-Wandlers 1 können aber auch Drücke erzeugt und/oder Drücke erfasst werden.

Ein weiteres Anwendungsgebiet des MEMS-Schallwandlers kann aber auch die Erzeugung und/oder Erfassung von Schallwellen im Ultraschallbereich sein. Der MEMS-Schallwandler kann beispielsweise in einem Ultraschallsensor, beispielsweise einem Abstandssensor, angeordnet sein.

Der MEMS-Wandler 1 umfasst ferner einen Träger 2, der ein Grundgerüst des MEMS-Wandlers 1 bilden kann. Der Träger 2 kann beispielsweise ein Halbleitersubstrat umfassen, das in einem Ätzverfahren hergestellt sein kann. Der Träger 2 kann beispielsweise aus Silizium ausgebildet sein und/oder die Form eines Wafers aufweisen. In der vorliegenden Ansicht sind zwei Träger 2 gezeigt. Der Träger 2 kann jedoch als Rahmen ausgebildet sein, sodass in dieser hier gezeigten Schnittansicht die beiden hier gezeigten Elemente des Trägers 2 zusammenhängend sind. Beispielsweise kann der Träger 2 in einer Draufsicht rechteckig ausgebildet sein. Die Draufsicht kann beispielsweise in Richtung einer im Folgenden erläuterten Hubachse 3 orientiert sein. Die Draufsicht kann beispielsweise parallel zur Hubachse 3 sein. Beispielsweise kann das zumindest eine Piezoelement 4 zumindest teilweise einem Inneren des Trägers 2 zugewandt sein, wenn der Träger 2 beispielsweise als Rahmen ausgebildet ist.

Am Träger 2 ist des Weiteren zumindest ein Piezoelement 4 angeordnet. Das zumindest eine Piezoelement 4 kann ferner mit dem Träger 2 gekoppelt sein. Das zumindest eine Piezoelement 4 kann entlang der gezeigten Hubachse 3 ausgelenkt werden. Das zumindest eine Piezoelement 4 kann dabei elektrische Signale in Auslenkungen umwandeln, sodass der MEMS-Wandler 1 als Lautsprecher betrieben wird bzw. die Schallwellen erzeugt werden können. Zusätzlich oder alternativ können mit Hilfe des zumindest einen Piezoelements 4 auch Auslenkungen in elektrische Signale umgewandelt werden, sodass der MEMS-Wandler 1 als Mikrofon betrieben wird bzw. die Schallwellen erfasst werden können. Mittels den Auslenkungen können aber auch Drücke erzeugt werden. Zusätzlich oder alternativ können auch Drücke erfasst werden, da diese eine Auslenkung des zumindest einen Piezoelements 4 hervorrufen.

Das zumindest eine Piezoelement 4 umfasst ein freies Ende 8, das sich entlang der Hubachse 3 auslenken kann.

Das Piezoelement 4 umfasst des Weiteren zumindest zwei Piezoschichten 5, 25. Die zumindest zwei Piezoschichten 5, 25 sind aus einem piezoelektrischen Material ausgebildet. Die zumindest zwei Piezoschichten 5, 25 können elektrische Signale in Auslenkungen und/oder Auslenkungen in elektrische Signale wandeln. Die zumindest zwei Piezoschichten 5, 25 können aus Scandium-Aluminium-Nitrit (ScAlN) ausgebildet sein.

Außerdem umfasst das Piezoelement 4 zumindest eine Trägerschicht 6. Diese ist mit den zumindest zwei Piezoschichten 5, 25 gekoppelt. Zumindest eine Piezoschicht 5, 25 ist hier zwischen dem Träger 2 und der zumindest einen Trägerschicht 6 angeordnet. Mit Hilfe der zumindest einen Trägerschicht 6, kann die zumindest eine Piezoschicht 5, 25 stabilisiert werden. Ferner kann mittels der zumindest einen Trägerschicht 6 verhindert werden, dass die zumindest eine Piezoschicht 5, 25 beim Auslenken bricht. Die zumindest eine Trägerschicht 6 kann auch als Trägerschicht für die zumindest eine Piezoschicht 5, 25 dienen.

Die Trägerschicht 6 kann beispielsweise aus einem Polymer ausgebildet sein. Die Trägerschicht 6 ist somit eine Polymerträgerschicht. Bei dem Polymer kann es sich um ein Polyamid handeln. Ein Polymer ist, insbesondere im Vergleich zu Silizium, weicher, sodass das Piezoelement 4 kleiner ausgebildet werden kann, wobei trotzdem hohe Auslenkungen des Piezoelements 4 möglich sind. Eine Performance bzw. Leistung des Piezoelements 4 hängt unter anderem von der Stärke der Auslenkung oder auch von der Elongation ab. Durch das weiche Polymer, insbesondere im Vergleich zu Silizium, sind gleichbleibende Auslenkungen möglich, bei geringeren Abmessungen, insbesondere bei einer geringeren Länge, des Piezoelements 4.

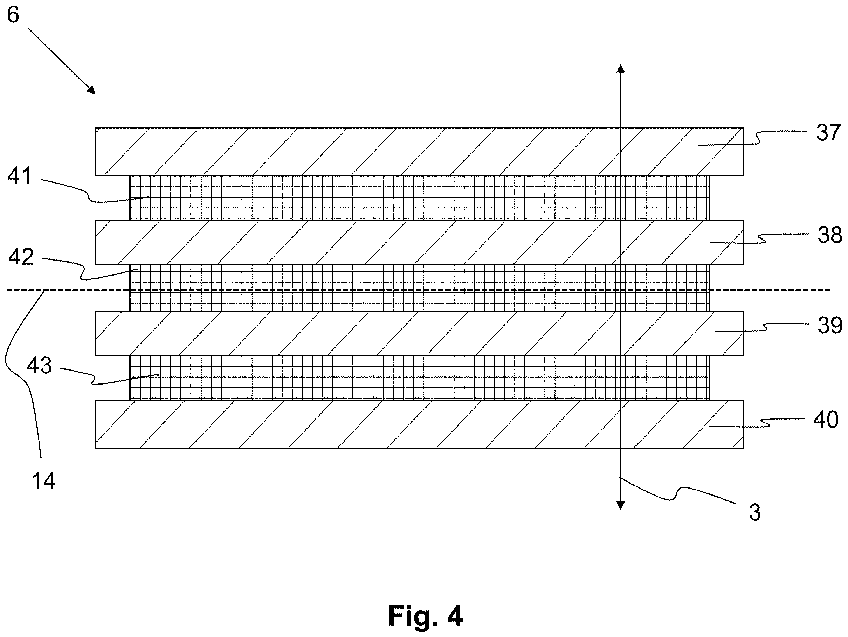

Alternativ kann die Trägerschicht 6 auch zumindest eine Metallschicht 41 - 43 und/oder zumindest eine Oxidschicht 37 - 40 aufweisen, wie es detaillierter in Figur 4 gezeigt ist.

Gemäß dem vorliegenden Ausführungsbeispiel umfasst der MEMS-Wandler 1 ein Koppelelement 9, mit dem das zumindest eine Piezoelement 4 mit einer hier gezeigten Membran 11 des MEMS-Wandlers 1 gekoppelt werden kann. Mithilfe des Koppelelements 9 können die Auslenkungen des Piezoelements 4 auf die Membran 11 übertragen werden, wenn mittels der Membran 11 die Schallwellen erzeugt werden, wenn der MEMS-Wandler 1 ein MEMS-Schallwandler ist. Zusätzlich oder alternativ können auch die Auslenkungen der Membranen 11, wenn mithilfe der Membran 11 die Schallwellen erfasst werden, auf das Piezoelement 4 übertragen werden, wenn der MEMS-Wandler 1 ein MEMS-Schallwandler ist.

Gemäß dem vorliegenden Ausführungsbeispiel ist das Piezoelement 4 mittels einem Federelement 10 mit dem Koppelelement 9 gekoppelt. Das Federelement 10 kann beispielsweise aus einem Polymer ausgebildet sein. Das Federelement 10 weist hierdurch eine Flexibilität auf.

Von Vorteil ist es, wenn, wie hier gezeigt ist, zwischen dem Koppelelement 9 und der Membran 11 eine Koppelplatte 12 angeordnet ist. Mittels der Koppelplatte 12 kann eine flächige Übertragung der Auslenkungen zwischen dem Koppelelement 9 und der Membran 11 erreicht werden. Gemäß dem vorliegenden Ausführungsbeispiel ist außerdem ein Membranrahmen 13 gezeigt, mit dem die Membran 11 auf dem Träger 2 angeordnet sein kann.

Des Weiteren weist das zumindest eine Piezoelement 4 eine Länge 33 auf. Die Länge 33 ist hier vom Träger 2 bis zu dem freien Ende 8 des zumindest einen Piezoelements 4 definiert. Die Länge 33 kann zwischen 0,5mm und 2mm betragen. Durch die Trägerschicht 6 kann das Piezoelement 4 diese Länge 33 aufweisen, wobei große Auslenkungen entlang der Hubachse 3 möglich sind. Die Auslenkung des zumindest einen Piezoelements 4, insbesondere an dem freien Ende 8, kann mindestens 3%, vorzugsweise mindestens 10%, betragen.

Eine Dicke 34 des zumindest einen Piezoelements 4 kann zwischen 2 µm und 50 µm betragen. Die Dicke 34 ist parallel zur Hubachse 3 und/oder senkrecht zu den Schichten des zumindest einen Piezoelements 4 orientiert (vgl. Figur 4).

Des Weiteren kann das zumindest eine Piezoelement 4 zumindest eine in dieser Figur nicht gezeigte Aussparung aufweisen. Die zumindest eine Aussparung kann sich zumindest teilweise zwischen der Oberseite 15 und der Unterseite 16 erstrecken. Die zumindest eine Aussparung kann sich von der Oberseite 15 und/oder von der Unterseite 16 in Richtung der entsprechend gegenüberliegenden Ober- bzw. Unterseite 15, 16 erstrecken. Mit Hilfe dieser Aussparungen können Spannungen im Piezoelement 4 bzw. in der zumindest einen Piezoschicht 5 und/oder in der zumindest einen Trägerschicht 6 vermindert werden. Die Oberseite 15 kann hierbei auch als erste Seite und die Unterseite 16 als zweite Seite bezeichnet werden.

Die Oberseite 15 ist hier der Membran 11 zugewandt. Die Unterseite 16 ist der Membran 11 abgewandt. Durch die Begriffe Oberseite 15 und Unterseite 16 sind auch die Begriffe oberhalb und unterhalb definiert. Die Begriffe Oberseite 15 und Unterseite 16 sowie oberhalb und unterhalb beziehen sich auf die Richtung der Hubachse 3.

Des Weiteren ist hier eine neutrale Ebene 14 gezeigt. Die neutrale Ebene 14 ist ein Begriff aus der Festigkeitslehre und wird auch als neutrale Faser bzw. Nulllinie bezeichnet. Die neutrale Faser bzw. neutrale Ebene 14 bzw. die Nulllinie ist dabei die Ebene bzw. Linie im Piezoelement 4, wo sich die Zug- und Druckspannung aufheben, sodass dort keine Spannung auftritt. Darüber und darunter wirken dagegen entweder Zug- oder Druckspannungen. Die Zug- oder Druckspannung tritt hierbei natürlich nur auf, wenn sich das Piezoelement 4 auslenkt. Wird das Piezoelement 4 beispielsweise nach oben, d. h. in Richtung vom Träger 2 weg, ausgelenkt, so wirkt in einem oberen Bereich des Piezoelements 4 Druckspannung und in einem unteren Bereich des Piezoelements 4 Zugspannung. Wenn sich dagegen das Piezoelement 4 nach unten, d. h. zum Träger 2 hin, ausgelenkt, so vertauschen sich die Druckspannung und die Zugspannung. In der neutralen Ebene 14 bzw. in der neutralen Schicht wirkt weder Zugspannung noch Druckspannung, wobei diese Ebene 14 bzw. diese Schicht zwischen einer Oberseite 15 und einer Unterseite 16 des Piezoelements 4 angeordnet ist. Mit Hilfe der ersten Piezoschicht 5 und der zweiten Piezoschicht 25 in Richtung der Hubachse 3 oberhalb und unterhalb der Trägerschicht 6 ist die Position der neutralen Faser bzw. neutralen Ebene 14 (oder Schicht) bzw. der Nulllinie in der Höhe bzw. in Richtung der Hubachse 3 angepasst. Da auch die beiden Piezoschichten 5, 25 zueinander gleich ausgebildet sind, d. h. aus demselben Material, beispielsweise AlScN, ausgebildet sind und/oder eine gleiche Dicke 34 aufweisen, ist die neutrale Ebene 14 mittig im Piezoelement 4 und/oder in der Trägerschicht 6 angeordnet.

Merkmale, welche bereits in der zumindest einen vorgegangenen Figur beschrieben sind, können der Einfachheit halber nicht nochmals erklärt werden. Ferner können Merkmale auch erst in dieser oder in zumindest einer der nachfolgenden Figuren beschrieben werden. Des Weiteren werden der Einfachheit halber für gleiche Merkmale gleiche Bezugszeichen verwendet. Außerdem können der Übersichtlichkeit halber nicht mehr alle Merkmale in den folgenden Figuren gezeigt und/oder mit einem Bezugszeichen versehen sein. Es können jedoch in einer oder mehreren der vorangegangenen Figuren gezeigte Merkmale auch in dieser oder in einer oder mehreren der nachfolgenden Figuren vorhanden sein. Ferner können der Übersichtlichkeit halber Merkmale auch erst in dieser oder in einer oder mehreren der nachfolgenden Figuren gezeigt und/oder mit einem Bezugszeichen versehen sein. Nichtsdestotrotz können Merkmale, welche erst in einer oder mehreren der nachfolgenden Figuren gezeigt sind, auch bereits in dieser oder einer vorangegangenen Figur vorhanden sein.

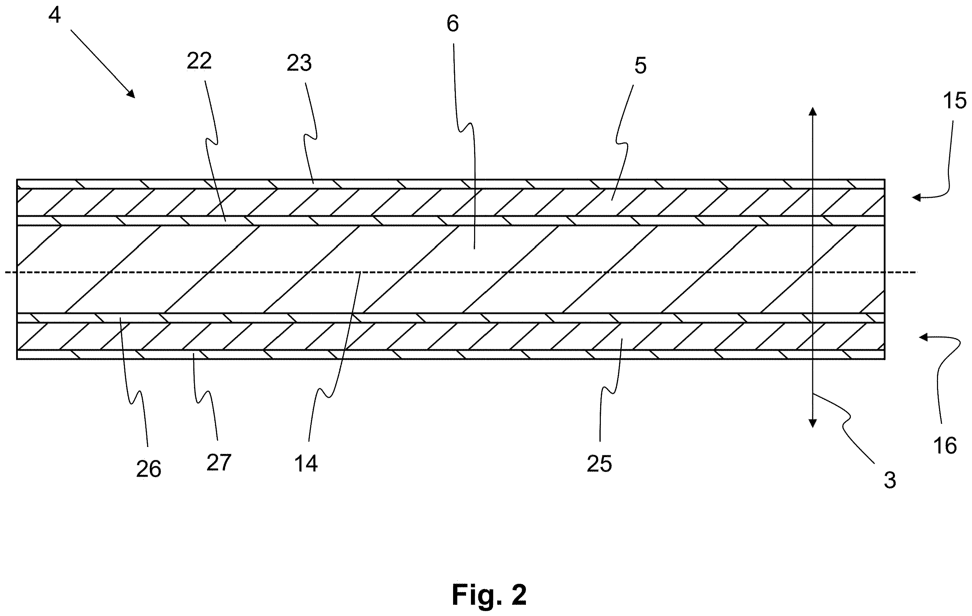

Figur 2 zeigt eine detailliertere schematische Schnittansicht des Piezoelements 4. Der Übersichtlichkeit halber wird der genauere Aufbau des Piezoelements 4 in dieser Figur 2 erläutert.

Hier sind die zumindest zwei Piezoschichten 5, 25 gezeigt, wobei eine Piezoschicht 5, nämlich die erste Piezoschicht 5, oberhalb bzw. auf der Oberseite 15 der Trägerschicht 6 und eine Piezoschicht 25, nämlich die zweite Piezoschicht 25, unterhalb bzw. auf der Unterseite 16 der Trägerschicht 6 angeordnet ist. Hierdurch kann ein symmetrischer Aufbau des Piezoelements 4 erzielt werden, sodass die neutrale Ebene 14 mittig im Piezoelement 4 bzw. in der Trägerschicht 6 angeordnet ist. Hierdurch sind die Auslenkeigenschaften des Piezoelements 4 verbessert. Beispielsweise können sich hierdurch Nichtlinearitäten der zumindest zwei Piezoschichten 5, 25 gegenseitig ausgleichen.

Ferner sind hier mehrere Elektrodenschichten 22, 23, 26, 27 gezeigt. In diesem Ausführungsbeispiel sind die erste und die zweite Elektrodenschicht 22, 23 der ersten Piezoschicht 5 und die dritte und vierte Elektrodenschicht 26, 27 der zweiten Piezoschicht 25 zugeordnet. Mit Hilfe der Elektrodenschichten 22, 23, 26, 27 können die Piezoschichten 5, 25 mit einem elektrischen Signal versorgt werden, sodass sie sich auslenken, oder es kann das elektrische Signal abgeführt werden, wenn sie selbst ausgelenkt werden.

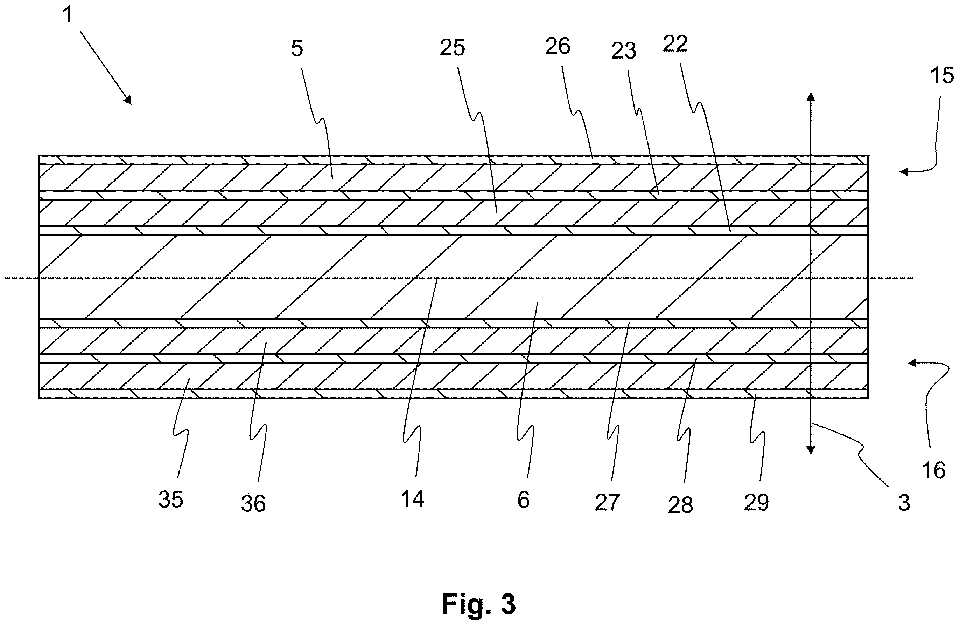

Figur 3 zeigt ein Ausführungsbeispiel des Piezoelements 4, das eine Trägerschicht 6 und vier Piezoschichten 5, 25, 35, 36, umfasst. In diesem Ausführungsbeispiel sind zwei Piezoschichten 5, 25, nämlich hier die erste und zweite Piezoschicht 5, 25, oberhalb und zwei Piezoschichten 35, 36, nämlich eine dritte und vierte Piezoschicht 35, 36, unterhalb der Trägerschicht 6 angeordnet. Infolgedessen kann die Leistung des Piezoelements 4 im Vergleich zum Piezoelement 4 mit zwei Piezoschichten 5, 25 der Figur 2 erhöht werden. In diesem Ausführungsbeispiel sind allerdings oberhalb und unterhalb der Trägerschicht 6 gleich viele Piezoschichten 5, 25, 35, 36 angeordnet, sodass das Piezoelement 4 wieder symmetrisch aufgebaut ist. Insbesondere ist die neutrale Ebene 14 mittig angeordnet.

Aufgrund der jeweils zwei Piezoschichten 5, 25, 35, 36 oberhalb und unterhalb der Trägerschicht 6 sind oberhalb und unterhalb der Trägerschicht 6 jeweils drei Elektrodenschichten 22, 23, 26 - 29 angeordnet. Zwischen jeweils zwei Elektrodenschichten 22, 23, 26 - 29 ist eine Piezoschicht 5, 25, 35, 36 angeordnet. In Richtung der Hubachse 3 ist somit beidseitig zu jeder Piezoschicht 5, 25, 35, 36 eine Elektrodenschicht 22, 23, 26 - 29 angeordnet. Hiermit kann jede Piezoschicht 5, 25, 35, 36 mit dem elektrischen Signal versorgt werden, oder es kann das elektrische Signal abgeführt werden.

Figur 4 zeigt ein Ausführungsbeispiel der Trägerschicht 6 in einer Schnittansicht. Wie hier zu sehen ist, ist die Trägerschicht 6 aus weiteren Schichten 37 - 43 ausgebildet. Die Trägerschicht 6 kann zumindest eine Oxidschicht 37 - 40 und/oder eine Metallschicht 41 - 43 umfassen. Hier ist die Hubachse 3 und die neutrale Ebene 14 eingezeichnet. Insbesondere mittels der Hubachse 3 ist wieder klar, was oberhalb und unterhalb bedeutet.

Die zumindest eine Metallschicht 41 - 43 kann vorzugsweise aus Aluminium ausgebildet sein. Zusätzlich oder alternativ kann die zumindest eine Oxidschicht 37 - 40 aus Siliziumoxid ausgebildet sein. Mittels dieser Materialien kann die Trägerschicht 6 mit bekannten Herstellungsverfahren, beispielsweise mittels Verfahren, die in der Halbleitertechnologie eingesetzt werden, ausgebildet werden.

Die zumindest eine Oxidschicht 37 - 40 und/oder zumindest eine Metallschicht 41 - 43 weisen ferner den Vorteil auf, dass diese thermisch bis zu hohen Temperaturen, beispielsweise bis 1200°C - 1400°C, beständig sind. Infolgedessen können die Piezoschichten 5, 25, 35, 36 und/oder die Elektrodenschichten 22, 23, 26 - 29 mittels Verfahren der Halbleitertechnologie aufgebracht werden. Beispielsweise können die Piezoschichten 5, 25, 35, 36 und/oder die Elektrodenschichten 22, 23, 26 - 29 mittels eines CVD-Verfahrens (chemische Gasphasenabscheidung) aufgebracht werden.

In diesem Ausführungsbeispiel umfasst die Trägerschicht 6 vier Oxidschichten 37 - 40 und drei Metallschichten 41 - 43, die, wie hier zu sehen ist, vorteilhafterweise abwechselnd in Richtung der Hubachse 3 übereinander angeordnet sind. In Richtung der Hubachse 3 ist außerdem oben und unten eine Oxidschicht 37, 40 angeordnet. Im Vergleich mit den vorangegangenen Figuren ist in Richtung der Hubachse 3 oberhalb der hier gezeigten ersten Oxidschicht 37 zumindest eine Piezoschicht 5, 25, 35, 36 und in Richtung der Hubachse 3 unterhalb der hier gezeigten vierten Oxidschicht 40 zumindest eine Piezoschicht 5, 25, 35, 36 angeordnet. Hierbei kann an die hier gezeigte erste und vierte Oxidschicht 37, 40 auch unmittelbar eine Elektrodenschicht 22, 23, 26 - 29 angrenzen. Erst an diese Elektrodenschicht 22, 23, 26 - 29 kann dann die Piezoschicht 5, 25, 35, 36 angrenzen. Dies ist allerdings nur der Fall, wenn eine Elektrode für die Piezoschicht 5, 25, 35, 36 auch als Elektrodenschicht 22, 23, 26 - 29 ausgebildet ist. Die Elektrode für die Piezoschicht 5, 25, 35, 36 kann auch an einer Stirnseite der Piezoschicht 5, 25, 35, 36 angeordnet sein. Dann könnte die Piezoschicht 5, 25, 35, 36 unmittelbar an die erste oder vierte Oxidschicht 37, 40 angrenzen.

Des Weiteren kann sich eine Elektrodenschicht 22, 23, 26 - 29 auch abschnittsweise zwischen Piezoschicht 5, 25, 35, 36 und der angrenzenden Oxidschicht 37 - 40 erstrecken.

Wie hier gezeigt ist, stehen die Oxidschichten 37 - 40 seitlich über die Metallschichten 41 - 43 weg. Zusätzlich oder alternativ können auch einige, insbesondere alle, Oxidschichten 37 - 40 und Metallschichten 41 - 43 bündig und/oder deckungsgleich sein.

Wie in der Figur 4 zu sehen ist, umfasst die hier gezeigte Trägerschicht 6 vier Oxidschichten 37 - 40 und drei Metallschichten 41 - 43. Alternativ kann die Trägerschicht 6 auch lediglich zwei Oxidschichten 37 - 40 und eine Metallschicht 41 - 43 umfassen. Weiterhin alternativ kann die Trägerschicht 6 auch mehrere Oxidschichten 37 - 40, beispielsweise elf, und mehrere Metallschichten 41 - 43, beispielsweise zehn, umfassen.

Von Vorteil ist es, wenn die Trägerschicht 6 in Richtung der Hubachse 3 oben und unten eine Oxidschicht 37 - 40 aufweist. Ferner kann die oberste und die unterste Schicht des schichtweisen Aufbaus der Trägerschicht 6 eine Oxidschicht 37 - 40 sein. Zusätzlich ist jeweils zwischen zwei Oxidschichten 37 - 40 eine Metallschicht 41 - 43 angeordnet. Somit ist die Anzahl der Oxidschichten 37 - 40 um eins größer als die Anzahl der Metallschichten 41 - 43.

Die Oxidschichten 37 - 40 weisen den Vorteil auf, dass diese gut weiterbearbeitet werden können. Beispielsweise können die Oxidschichten 37 - 40 mittels chemisch-mechanischem Polierens bearbeitet werden. Dadurch wird eine flache und/oder ebene Fläche auf der Oxidschicht 37 - 40 gebildet, auf der dann die zumindest eine Piezoschicht 5, 25, 35, 36 und/oder die Elektrodenschicht 22, 23, 26 - 29 angeordnet wird. Deshalb ist es von Vorteil, wenn die oberste und die unterste Schicht der Trägerschicht eine Oxidschicht 37 - 40 ist.

Hier sind vier Oxidschichten 37 - 40 und drei Metallschichten 41 - 43, um eine Dicke 34 des Piezoelements 4 von ungefähr 7µm zu erhalten, was vorteilhaft für die Auslenkung und für die Leistungsfähigkeit des Piezoelements 4 ist. Die Anzahl der Oxidschichten 37 - 40 und Metallschichten 41 - 43 und somit die Dicke 34 des Piezoelements 4 hängt hierbei auch von der Länge 33 des Piezoelements 4 ab.

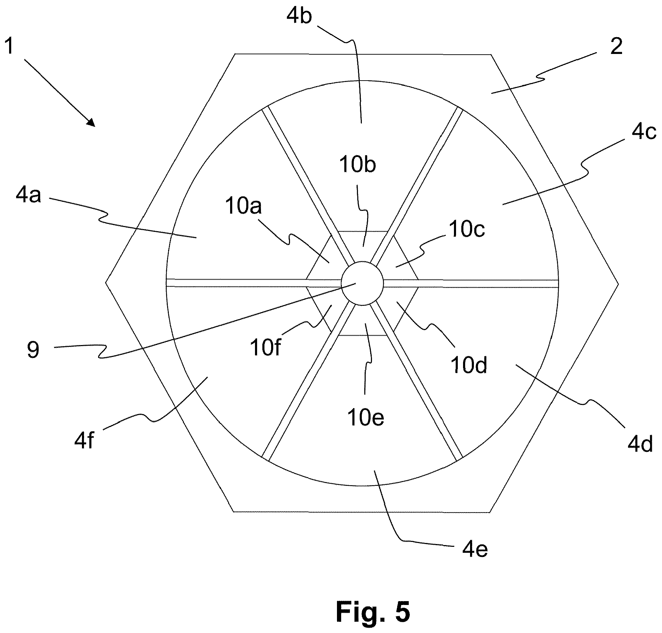

Figur 5 zeigt eine Draufsicht auf ein Ausführungsbeispiel des MEMS-Wandlers 1. Der Träger 2 ist in diesem Ausführungsbeispiel sechseckig ausgebildet. Des Weiteren sind hier sechs Piezoelemente 4a - 4f gezeigt. Außerdem weist jedes der sechs Piezoelemente 4a - 4f ein zugeordnetes Federelement 10a - 10f auf. Die sechs Piezoelemente 4a - 4f und/oder die sechs Federelemente 10a - 10f sind mit dem Koppelelement 9 gekoppelt, das die Piezoelemente 4a - 4f mit der hier nicht gezeigten Membran 11 koppelt. Mit den mehreren Piezoelementen 4a - 4f kann die Leistungsfähigkeit des MEMS-Wandlers 1 erhöht werden.

### Bezugszeichenliste

- 1: MEMS-Wandlers
- 2: Träger
- 3: Hubachse
- 4: Piezoelement
- 5: erste Piezoschicht
- 6: Trägerschicht
- 8: freies Ende
- 9: Koppelelement
- 10: Federelement
- 11: Membran
- 12: erste Koppelplatte
- 13: Membranrahmen
- 14: neutrale Ebene
- 15: Oberseite
- 16: Unterseite
- 22: erste Elektrodenschicht
- 23: zweite Elektrodenschicht
- 25: zweite Piezoschicht
- 26: dritte Elektrodenschicht
- 27: vierte Elektrodenschicht
- 28: fünfte Elektrodenschicht
- 29: sechste Elektrodenschicht
- 33: Länge
- 34: Dicke
- 35: dritte Piezoschicht
- 36: vierte Piezoschicht
- 37: erste Oxidschicht
- 38: zweite Oxidschicht
- 39: dritte Oxidschicht
- 40: vierte Oxidschicht
- 41: erste Metallschicht
- 42: zweite Metallschicht
- 43: dritte Metallschicht

## Patentansprüche

1. MEMS-Wandler (1), insbesondere MEMS-Schallwandlereinheit, vorzugsweise zum Erzeugen und/oder Erfassen von Schallwellen im hörbaren Wellenlängenspektrum und/oder im Ultraschallbereich, mit einem Träger (2) und
mit zumindest einem am Träger (2) angeordneten und in Richtung einer Hubachse (3) auslenkbaren Piezoelement (4),
das zumindest zwei Piezoschichten (5, 25, 35, 36) und zumindest eine Trägerschicht (6) aufweist, wobei mittels der zumindest einen Piezoschicht (5, 25, 35, 36) elektrische Signale und Auslenkungen des Piezoelements (4) ineinander umwandelbar sind,
**dadurch gekennzeichnet,**
**dass** die Trägerschicht (6) in Richtung der Hubachse (3) zwischen zwei Piezoschichten (5, 25, 35, 36) angeordnet ist.

2. MEMS-Wandler nach dem vorherigen Anspruch, **dadurch gekennzeichnet, dass** die Piezoschichten (5, 25, 35, 36) aus Scandium-Aluminium-Nitrit ausgebildet sind, wobei ein Scandiumanteil zwischen 30% und 70%, vorzugweise 30%, 40 % oder 50%, beträgt, und/oder dass die zumindest eine Trägerschicht (6) aus einem Polymer, insbesondere einem Polyamid, ausgebildet ist.

3. MEMS-Wandler nach einem oder mehreren der vorherigen Ansprüche, **dadurch gekennzeichnet, dass** in Richtung der Hubachse (3) unterhalb und oberhalb der Trägerschicht (6) eine Piezoschicht (5, 25, 35, 36) angeordnet ist und/oder
dass in Richtung der Hubachse (3) unterhalb und oberhalb der Trägerschicht (6) jeweils die gleiche Anzahl an Piezoschichten (5, 25, 35, 36) angeordnet sind und/oder
dass in Richtung der Hubachse (3) unterhalb und oberhalb der Trägerschicht (6) jeweils zwei Piezoschichten (5, 25, 35, 36) angeordnet sind.

4. MEMS-Wandler nach dem vorherigen Anspruch, **dadurch gekennzeichnet, dass** die zumindest eine Trägerschicht (6) zumindest eine Metallschicht (41 - 43), insbesondere eine Aluminiumschicht, und/oder zumindest eine Oxidschicht (37 - 40), insbesondere eine Siliziumoxidschicht, umfasst.

5. MEMS-Wandler nach dem vorherigen Anspruch, **dadurch gekennzeichnet, dass** die Trägerschicht (6) mehrere Metallschichten (41 - 43) und mehrere Oxidschichten (37 - 40) umfasst, die vorzugsweise abwechselnd übereinander angeordnet sind.

6. MEMS-Wandler nach dem vorherigen Anspruch, **dadurch gekennzeichnet, dass** in Richtung der Hubachse (3) die oberste und die unterste Schicht eine Oxidschicht (37 - 40) ist.

7. MEMS-Wandler nach einem oder mehreren der vorherigen Ansprüche, **dadurch gekennzeichnet, dass** das Piezoelement (4) in dessen Längsrichtung eine Länge (33), insbesondere vom Träger (2) bis zu einem freien Ende (8) des Piezoelements (4), zwischen 0,5 mm und 2 mm aufweist.

8. MEMS-Wandler nach einem oder mehreren der vorherigen Ansprüche, **dadurch gekennzeichnet, dass** das zumindest eine Piezoelement (4) mehrere, insbesondere zwischen zwei und sechs, vorzugsweise vier, Piezoschichten (5, 25, 35, 36) umfasst und/oder dass das zumindest eine Piezoelement (4) zumindest eine Elektrodenschicht (22, 23, 26 - 29) umfasst und/oder
dass das zumindest eine Piezoelement (4) zumindest eine Isolationsschicht umfasst.

9. MEMS-Wandler nach einem oder mehreren der vorherigen Ansprüche, **dadurch gekennzeichnet, dass** der MEMS-Wandler (1) ein Koppelelement (9) umfasst, mit dem das zumindest eine Piezoelement (4) mit einer Membran (11) koppelbar ist.

10. MEMS-Wandler nach einem oder mehreren der vorherigen Ansprüche, **dadurch gekennzeichnet, dass** das Piezoelement (4) und das Koppelelement (9) mittels zumindest eines Federelements (10) miteinander gekoppelt sind, wobei das zumindest eine Federelement (10) in Längsrichtung des Piezoelements (4) vorzugsweise zwischen der Trägerschicht (6) und dem Koppelelement (9) angeordnet ist.

11. MEMS-Wandler nach einem oder mehreren der vorherigen Ansprüche, **dadurch gekennzeichnet, dass** das Federelement (10), vorzugsweise ausschließlich, durch die Trägerschicht (6) und/oder aus dem oder einem Polymer ausgebildet ist.

12. Verwendung einer Trägerschicht (6) für einen MEMS-Wandler (1), wobei der MEMS-Wandler (1) zumindest gemäß einem der vorherigen Ansprüche ausgebildet ist und/oder wobei die Trägerschicht (6) gemäß zumindest einem der Ansprüche ausgebildet ist.

13. Verfahren zur Herstellung eines MEMS-Wandlers (1), insbesondere MEMS-Schallwandlereinheit, vorzugsweise zum Erzeugen und/oder Erfassen von Schallwellen im hörbaren Wellenlängenspektrum und/oder im Ultraschallbereich,
wobei der MEMS-Wandler (1) vorzugsweise zumindest ein Merkmal der vorangegangenen Ansprüche aufweist,
bei dem an einem Träger (2) zumindest ein in Richtung einer Hubachse (3) auslenkbares Piezoelement (4) angeordnet wird,
das zumindest zwei Piezoschichten (5, 25, 35, 36) und zumindest eine Trägerschicht (6) aufweist, wobei mittels den zumindest zwei Piezoschichten (5, 25, 35, 36) elektrische Signale und Auslenkungen des Piezoelements (4) ineinander umwandelbar sind,
**dadurch gekennzeichnet,**
**dass** die Trägerschicht (6) zwischen zumindest zwei Piezoschichten (5, 25, 35, 36) angeordnet wird.

14. Verfahren nach dem vorherigen Anspruch, **dadurch gekennzeichnet, dass** eine Oxidschicht (37 - 40), insbesondere eine Siliziumoxidschicht, der Trägerschicht (6) mittels chemisch-mechanischem Polierens bearbeitet wird und/oder
dass die Piezoschichten (5, 25, 35, 36) mittels Halbleiterherstellungsverfahren auf der Trägerschicht (6) ausgebildet werden.

15. Verfahren nach einem oder mehreren der vorherigen Ansprüche,
**dadurch gekennzeichnet, dass** die Piezoschichten (5, 25, 35, 36) auf der Trägerschicht (6), insbesondere auf der Oxidschicht (37 - 40), abgeschieden werden und/oder
dass die Piezoschichten (5, 25, 35, 36) auf der Trägerschicht (6) und/oder die Trägerschicht (6) mittels chemischer Gasphasenabscheidung ausgebildet werden und/oder
dass nach dem Ausbilden der Piezoschichten (5, 25, 35, 36) und/oder der Trägerschicht (6) zumindest ein Bereich, insbesondere mittels Ätzens, entfernt wird.
